# EUROPEAN PATENT APPLICATION

(11) **EP 4 589 574 A1**
(43) Date of publication of application: **23.07.2025**
(21) Application number: 23946961.2
(22) Date of filing: 28.07.2023
(51) Int. Cl.: G09F 9/30

(54) **DISPLAY DEVICE AND INJECTION MOLD**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: ZHU, Xi, Beijing 100176 (CN); LI, Chen, Beijing 100176 (CN); SHU, Yang, Beijing 100176 (CN); TANG, Qiang, Beijing 100176 (CN); FAN, Xu, Beijing 100176 (CN); ZHANG, Lei, Beijing 100176 (CN); ZHANG, Chen, Beijing 100176 (CN); FANG, Zheng, Beijing 100176 (CN); YAO, Jianli, Beijing 100176 (CN)
(74) Representative: Durán-Corretjer, S.L.P.
(86) International application number: PCT/CN2023/110000
(87) International publication number: WO 2025/025005

(57) **Abstract**

A display device and an injection mold. The display device comprises: a display substrate (10); a cover plate (23) provided on one side of the display substrate (10), wherein the corner of the cover plate (23) is provided with a chamfer (231), the chamfer (231) is located on the side of the cover plate (23) close to the display substrate (10), the chamfer (231) has a height in the thickness direction of the cover plate (23), the ratio of the height of the chamfer (231) to the maximum thickness of the cover plate (23) is greater than or equal to 0.03 and less than or equal to 0.5, the chamfer (231) has a beveled edge, and the included angle between the beveled edge and the plane where the display device (10) is located is greater than or equal to 50 degrees and less than or equal to 80 degrees; and an injection molded edge sealing member (40) comprising a first injection molding part (41) and a second injection molding part (42), at least part of the first injection molding part (41) being arranged on the peripheral side of the cover plate (23), and at least part of the second injection molding part (42) being arranged on the peripheral side of the display substrate (10).

## Description

### Technical Field

The present disclosure relates to, but is not limited to, the field of display technologies, in particular to a display device and an injection mold.

### Background

In a display device, a display substrate is generally attached to a cover plate, and then the cover plate is connected with a middle bezel, so that the middle bezel supports the display substrate through the cover plate. However, because the display substrate is attached to a side of the cover plate, when the middle bezel is connected with the cover plate, it is necessary to keep a certain distance from an edge of the display substrate to avoid interference with the display substrate. Therefore, the cover plate needs to retain a width for mounting the middle bezel and a width for avoiding interference between the middle bezel and the display substrate, thus increasing a width of a bezel of the display device.

A module injection molding process can reduce a width of a bezel area of the display device, but it cannot solve the problem of light leakage at a narrow bezel of the display device.

### Summary

The following is a summary of subject matter described herein in detail. This summary is not intended to limit the protection scope of the claims.

A display device, including:
a display substrate;
a cover plate, provided on a side of the display substrate; wherein a chamfer is provided at a corner position of the cover plate, the chamfer is on a side of the cover plate close to the display substrate, the chamfer has a height in a thickness direction of the cover plate, a ratio of the height of the chamfer to a maximum thickness of the cover plate is greater than or equal to 0.03 and less than or equal to 0.5, the chamfer has a bevel edge, and an included angle between the bevel edge and a plane where the display device is located is greater than or equal to 50 degrees and less than or equal to 80 degrees;
a light shield layer, wherein the light shield layer is provided between the display substrate and the cover plate and an orthographic projection of the light shield layer on the plane where the display device is located is overlapped with an orthographic projection of an edge area the cover plate on the plane where the display device is located; and
an injection molded edge sealing member, including a first injection molded part and a second injection molded part, wherein at least a portion of the first injection molded part is provided on a peripheral side of the cover plate and at least a portion of the second injection molded part is provided on a peripheral side of the display substrate.

In an exemplary implementation, the ratio of the height of the chamfer to the maximum thickness of the cover plate is greater than or equal to 0.04 and less than or equal to 0.4.

In an exemplary implementation, the ratio of the height of the chamfer to the maximum thickness of the cover plate is greater than or equal to 0.1 and less than or equal to 0.2.

In an exemplary implementation, a first end of the first injection molded part is connected with the second injection molded part, and an end face of a second end of the first injection molded part is substantially flush with a surface of the cover plate away from the display substrate.

In an exemplary implementation, the first injection molded part and the second injection molded part are connected as a whole and include a same material.

In an exemplary implementation, the first injection molded part is annular and is provided around the periphery of the cover plate.

In an exemplary implementation, a width of the annulus of the first injection molded part is greater than or equal to 0.05 mm and less than or equal to 1mm.

In an exemplary implementation, at least a portion of the second injection molded edge sealing part is provided in the display substrate.

In an exemplary implementation, a middle bezel is also included, the middle bezel including a side bezel and a bottom bezel, wherein the side bezel is provided on a side of the injection molded edge sealing member away from the cover plate; and the bottom bezel is on a side of the display substrate away from the cover plate.

In an exemplary implementation, an orthographic projection of the side bezel of the middle bezel on the plane where the display device is located is not overlapped with an orthographic projection of the cover plate on the plane where the display device is located.

In an exemplary implementation, the injection molded edge sealing member further includes a third injection molded part and the third injection molded part is provided between the display substrate and the bottom bezel.

In an exemplary implementation, the third injection molded part and the second injection molded part are connected as a whole and include a same material.

In an exemplary implementation, a sealant layer is further included and the sealant layer is provided between the injection molded edge sealing member and the middle bezel.

In an exemplary implementation, a middle bezel is further included, wherein the middle bezel includes a bottom bezel, the bottom bezel is on a side of the display substrate away from the cover plate, and the injection molded edge sealing member is provided on the bottom bezel.

In an exemplary implementation, the cover plate has an outer surface on a side away from the display substrate and an edge area of the outer surface is arc-shaped.

In an exemplary implementation, the cover plate has an outer surface on a side away from the display substrate and the outer surface is planar.

In an exemplary implementation, the injection molded edge sealing member has a first side surface on a side away from a peripheral side face of the cover plate, the first side surface is arc-shaped, and the first side surface of the injection molded edge sealing member is connected with the edge area of the outer surface of the cover plate to form an arc surface.

In an exemplary implementation, the injection molded edge sealing member has a top surface on a side away from the bottom bezel, a first side surface on a side away from a peripheral side face of the cover plate, and a filleted corner connecting the top surface with the first side surface, the top surface is planar, and the top surface is substantially flush with the outer surface of the cover plate.

In an exemplary implementation, the injection molded edge sealing member has a first side surface on a side away from a peripheral side face of the cover plate, the first side surface is arc-shaped, the bottom bezel has a second side surface, the second side surface is arc-shaped, and the first side surface is connected with the second side surface to form an arc surface.

In an exemplary implementation, the injection molded edge sealing member has a first side surface on a side away from a peripheral side face of the cover plate, the first side surface is planar, the bottom bezel has a second side surface, the second side surface is planar, and the first side surface is substantially flush with the second side surface.

In an exemplary implementation, the injection molded edge sealing member has a bottom surface on a side close to the bottom bezel, the bottom surface is planar, the bottom bezel has an upper surface on a side close to the injection molded edge sealing member, the upper surface is planar, and the bottom surface is connected with the upper surface.

In an exemplary implementation, the injection molded edge sealing member has a bottom surface on a side close to the bottom bezel, the bottom surface is provided with a first positioning clamp groove, the bottom bezel has an upper surface on a side close to the injection molded edge sealing member, the upper surface is provided with a first positioning protrusion, and the first positioning protrusion is engaged with the first positioning clamp groove.

In an exemplary implementation, the first positioning clamp groove is in a middle area of the bottom surface of the injection molded edge sealing member and the first positioning protrusion is in a middle area of the upper surface of the bottom bezel; or, the first positioning clamp groove is in an edge area of the bottom surface of the injection molded edge sealing member and the first positioning protrusion is in an edge area of the upper surface of the bottom bezel.

In an exemplary implementation, a section of the first positioning protrusion perpendicular to the plane where the display device is located includes at least one of a rectangle, a trapezoid, a triangle, and an elongated shape provided obliquely with respect to the plane where the display device is located.

In an exemplary implementation, a section of the first positioning clamp groove perpendicular to the plane where the display device is located includes at least one of a rectangle, a trapezoid, a triangle, and an elongated shape provided obliquely with respect to the plane where the display device is located.

In an exemplary implementation, the injection molded edge sealing member has a bottom surface on a side close to the bottom bezel, the bottom surface is provided with a second positioning protrusion, the bottom bezel has an upper surface on a side close to the injection molded edge sealing member, the upper surface is provided with a second positioning clamp groove, and the second positioning protrusion is engaged with the second positioning clamp groove.

In an exemplary implementation, the second positioning protrusion is in an middle area of the bottom surface of the injection molded edge sealing member and the second positioning clamp groove is in an middle area of the upper surface of the bottom bezel; or, the second positioning protrusion is in an edge area of the bottom surface of the injection molded edge sealing member and the second positioning clamp groove is in an edge area of the upper surface of the bottom bezel.

In an exemplary implementation, a section of the second positioning protrusion perpendicular to the plane where the display device is located includes at least one of a rectangle, a trapezoid, a triangle, and an elongated shape provided obliquely with respect to the plane where the display device is located.

In an exemplary implementation, a section of the second positioning clamp groove perpendicular to the plane where the display device is located includes at least one of a rectangle, a trapezoid, a triangle, and an elongated shape provided obliquely with respect to the plane where the display device is located.

In an exemplary implementation, the display substrate includes a first fixation region, a bending region and a second fixation region provided continuously and the second fixation region is provided on a backlight side of the first fixation region through the bending region.

In another aspect, the present disclosure provides an injection mold, including an upper mold core and a lower mold core, wherein the upper mold core and the lower mold core are configured to enclose the display substrate and the cover plate in the display device as described in any one of the embodiments to form an injection mold cavity connected with edges of the display substrate and the cover plate, the injection mold cavity is configured to accommodate an injection mold fluid forming the injection molded edge sealing member in the display device, and the injection mold cavity includes an inner side face, the inner side face is at the peripheral side of the cover plate, and a gap is formed between the inner side face and the peripheral side face of the cover plate.

In an exemplary implementation, a junction of the upper mold core and the lower mold core is substantially flush with a surface of the cover plate away from the display substrate.

In an exemplary implementation, a degassing hole connected with the cover plate is provided in the lower mold core.

Other aspects may become clear after the accompanying drawings and the detailed description are read and understood.

### Brief Description of Drawings

Accompanying drawings are used for providing an understanding for technical solutions of the present application and form a part of the specification, are used for explaining the technical solutions of the present application together with embodiments of the present application, and do not constitute a limitation on the technical solutions of the present application.
FIG. 1a is a first schematic diagram of a sectional structure of a display device.
FIG. 1b is a second schematic diagram of a sectional structure of a display device.
FIG. 2 is a schematic diagram of a planar structure of a display device according to an embodiment of the present application.
FIG. 3 is a schematic diagram of a sectional structure of a display device according to an embodiment of the present application.
FIG. 4a is a schematic diagram of a sectional structure of a display device according to an embodiment of the present application.
FIG. 4b is a schematic diagram of a sectional structure of another display device according to an embodiment of the present application.
FIG. 5 is a schematic diagram of a planar structure of a first injection molded edge sealing part of a display device according to an embodiment of the present application.
FIG. 6a is a schematic diagram of a sectional structure of a cover plate in a display device.
FIG. 6b is a simulation diagram of light leakage of the display device in FIG. 6a.
FIG. 7a is a schematic diagram of a sectional structure of a cover plate in a display device according to an embodiment of the present application.
FIG. 7b is a simulation diagram of light leakage of the display device in FIG. 7a.
FIG. 8 is an enlarged view of a chamfer of a cover plate in a display device according to an embodiment of the present application.
FIG. 9 is a schematic diagram of a sectional structure of an injection mold according to an embodiment of the present application.
FIG. 10 is an enlarged view of an injection mold according to an embodiment of the present application.
FIG. 11a is a schematic diagram of a sectional structure of a cover plate and an injection molded edge sealing member of a display device according to an embodiment of the present application.
FIG. 11b is a schematic diagram of a sectional structure of a cover plate and an injection molded edge sealing member of another display device according to an embodiment of the present application.
FIG. 12a is an enlarged view of a first positioning clamp groove and a first positioning protrusion of a display device according to an embodiment of the present application.
FIG. 12b is an enlarged view of a first positioning clamp groove and a first positioning protrusion of another display device according to an embodiment of the present application.
FIG. 12c is an enlarged view of a first positioning clamp groove and a first positioning protrusion of another display device according to an embodiment of the present application.
FIG. 12d is an enlarged view of a first positioning clamp groove and a first positioning protrusion of another display device according to an embodiment of the present application.
FIG. 13 is a schematic diagram of a sectional structure of a cover plate and an injection molded edge sealing member of another display device according to an embodiment of the present application.
FIG. 14 is a schematic diagram of a sectional structure of a cover plate and an injection molded edge sealing member of another display device according to an embodiment of the present application.
FIG. 15 is a schematic diagram of a sectional structure of a cover plate and an injection molded edge sealing member of another display device according to an embodiment of the present application.
FIG. 16 is a schematic diagram of a sectional structure of a cover plate and an injection molded edge sealing member of another display device according to an embodiment of the present application.
FIG. 17a is an enlarged view of a second positioning clamp groove and a second positioning protrusion of a display device according to an embodiment of the present application.
FIG. 17b is an enlarged view of a second positioning clamp groove and a second positioning protrusion of a display device according to an embodiment of the present application.
FIG. 17c is an enlarged view of a second positioning clamp groove and a second positioning protrusion of a display device according to an embodiment of the present application.
FIG. 17d is an enlarged view of a second positioning clamp groove and a second positioning protrusion of a display device according to an embodiment of the present application.
FIG. 18 is a schematic diagram of a sectional structure of a cover plate and an injection molded edge sealing member of another display device according to an embodiment of the present application.
FIG. 19a is an enlarged view of a junction of an injection molded edge sealing member and a middle bezel of a display device according to an embodiment of the present application.
FIG. 19b is an enlarged view of a junction of an injection molded edge sealing member and a middle bezel of another display device according to an embodiment of the present application.
FIG. 19c is an enlarged view of a junction of an injection molded edge sealing member and a middle bezel of another display device according to an embodiment of the present application.
FIG. 19d is an enlarged view of a junction of an injection molded edge sealing member and a middle bezel of another display device according to an embodiment of the present application.
FIG. 20 is a schematic diagram of a sectional structure of a cover plate and an injection molded edge sealing member of another display device according to an embodiment of the present application.
FIG. 21 is a schematic diagram of a sectional structure of a cover plate and an injection molded edge sealing member of another display device according to an embodiment of the present application.

### Detailed Description

To make the objectives, technical solutions, and advantages of the present disclosure clearer, the embodiments of the present disclosure will be described in detail below in with reference to the accompany drawings. It is to be noted that the implementations may be implemented in various forms. Those of ordinary skills in the art can easily understand such a fact that implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

In the accompanying drawings, a size of each composition element, a thickness of a layer, or a region may be exaggerated sometimes for clarity. Therefore, an implementation of the present disclosure is not always limited to the size, and the shape and size of each component in the drawings do not reflect an actual scale. **In** addition, the accompanying drawings schematically illustrate ideal examples, and an implementation of the present disclosure is not limited to shapes, numerical values, or the like shown in the drawings.

Ordinal numerals "first", "second", "third", etc., in the specification are set not to form limitations on numbers but only to avoid confusion between composition elements.

**In** the specification, for convenience, expressions "central", "above", "below", "front", "back", "vertical", "horizontal", "top", "bottom", "inside", "outside", etc., indicating directional or positional relationships are used to illustrate positional relationships between the composition elements, not to indicate or imply that involved devices or elements are required to have specific orientations and be structured and operated with the specific orientations but only to easily and simply describe the present specification, and thus should not be construed as limitations on the present disclosure. The positional relationships between the composition elements may be changed as appropriate according to a direction according to which each composition element is described. Therefore, appropriate replacements based on situations are allowed, which is not limited to the expressions in the specification.

In the specification, unless otherwise specified and defined, terms "mounting", "mutual connection", and "connection" should be understood in a broad sense. For example, it may be a fixed connection, a detachable connection, or an integral connection; it may be a mechanical connection or a connection; it may be a direct connection, an indirect connection through a middleware, or internal communication inside two elements. Those of ordinary skills in the art can understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In cases that transistors with opposite polarities are used, or a current direction changes during operation of a circuit, or the like, functions of the "source electrode" and the "drain electrode" are sometimes interchangeable. Therefore, the "source electrode" and the "drain electrode" are interchangeable in the specification.

In the specification, a "connection" includes a case where composition elements are connected together through an element with a certain electrical action. An "element with a certain electrical action" is not particularly limited as long as electric signals between the connected composition elements may be sent and received. Examples of the "element with the certain electrical action" not only include an electrode and a wiring, but also include a switch element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive film" sometimes. Similarly, an "insulation film" may be replaced with an "insulation layer" sometimes.

In the present disclosure, "about" means that a boundary is not defined strictly and numerical values within a range of process and measurement tolerances are allowed.

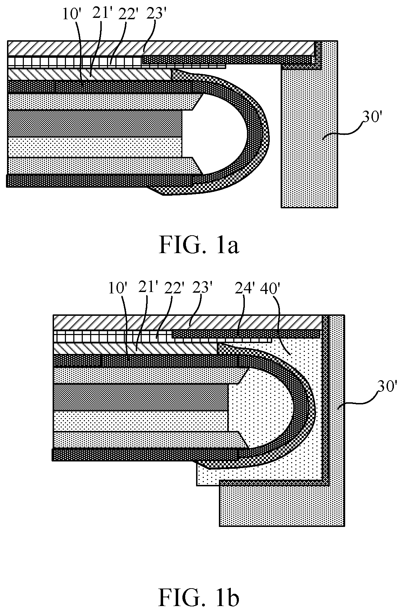

FIG. 1a is a first schematic diagram of a sectional structure of a display device. As shown in FIG. 1a, a bonding area of the display device may include a display substrate 10', a polarizer 21' provided on a light emitting side of the display substrate 10', an optical adhesive layer 22' provided on a side of the polarizer 21' away from the display substrate 10, and a cover plate 23' provided on a side of the optical adhesive layer 22' away from the display substrate 10.

In an exemplary implementation, the bonding area of the display device may further include a middle bezel 30', a mounting groove is provided on the middle bezel 30', and an edge of the cover plate 23' is provided in the mounting groove such that the cover plate 23' is fixed to the middle bezel 30'.

According to a research from the inventors of the present application, the middle bezel 30' of the display device shown in FIG. 1a needs to be reserved with a mounting groove for connection with the cover plate 23', resulting in a large size of the middle bezel 30', thus making it impossible to achieve a narrow bezel.

FIG. 1b is a second schematic diagram of a sectional structure of a display device. As shown in FIG. 1b, the bonding area of the display device may include a display substrate 10', a polarizer 21' provided on a light emitting side of the display substrate 10', an optical adhesive layer 22' provided on a side of the polarizer 21' away from the display substrate 10, and a cover plate 23' provided on a side of the optical adhesive layer 22' away from the display substrate 10.

In an exemplary implementation, the bonding area of the display device may further include a middle bezel 30', the middle bezel 30' is connected with a peripheral side face of the cover plate 23', and an injection molded edge sealing member 40' is provided between the middle bezel 30' and a peripheral side face of the display substrate 10'.

According to a research from the inventors of the present application, in order to prevent light leakage at an edge area of the cover plate 23', it is possible to provide a light shield layer 24' on a surface of an edge area of the cover plate 23' close to the display substrate 10', and the light shield layer 24' is configured to block light from being emitted from the edge area of the cover plate 23'. Due to tolerance in preparation process, the light shield layer 24' cannot completely cover the edge area of the cover plate 23', a peripheral side face of the light shield layer 24' is provided to retract inwardly with respect to the peripheral side face of the cover plate 23', and there is a gap between the peripheral side face of the light shield layer 24' and the peripheral side face of the cover plate 23', and the gap may cause light leakage.

The present disclosure provides a display device including:
a display substrate;
a cover plate, provided on a side of the display substrate;
a middle bezel, including a side bezel and a bottom bezel, wherein the side bezel is provided at a peripheral side of the display substrate and a peripheral side of the cover plate; and the bottom bezel is at a side of the display substrate away from the cover plate; and
an injection molded edge sealing member, including a first injection molded part and a second injection molded part, wherein at least part of the first injection molded part is provided between a peripheral side face of the cover plate and the side bezel and at least part of the second injection molded part is provided between a peripheral side face of the display substrate and the side bezel.

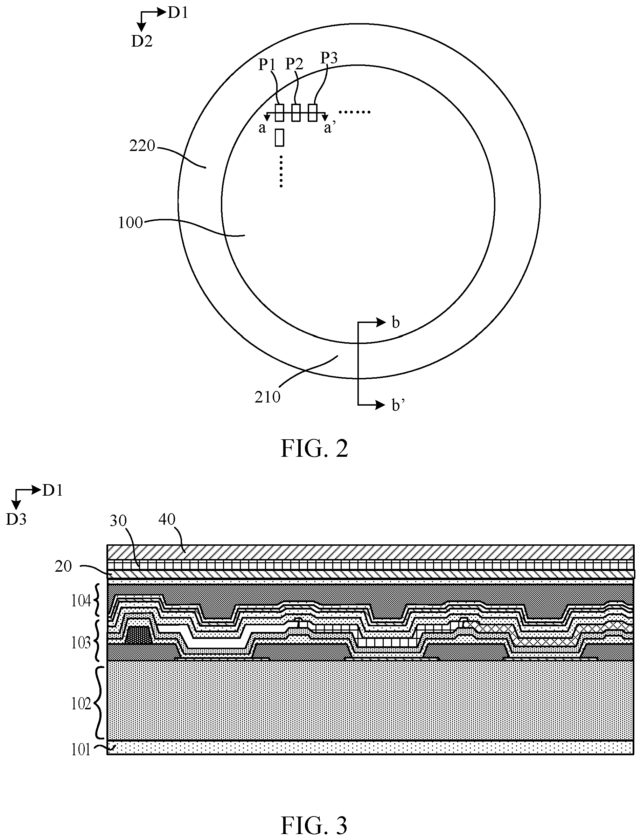

FIG. 2 is a schematic diagram of a planar structure of a display device according to an embodiment of the present application. In an exemplary implementation, as shown in FIG. 2, the display device may include a display area 100 and a bezel area 220 on a periphery of the display area 100, and the bezel area 220 at least includes a bonding area 210 on a side of the display area 100. The display area 100 of the display device may include multiple pixel units and at least one of the pixel units may include a first sub-pixel P1 emitting a first color light, a second sub-pixel P2 emitting a second color light, and a third sub-pixel P3 emitting a third color light. Each sub-pixel may include a circuit unit and a light emitting unit. The circuit unit may at least include a pixel drive circuit, the pixel drive circuit is connected with a scan signal line, a data signal line, and a light emitting signal line respectively, and is configured to receive a data voltage transmitted by the data signal line and output a corresponding current to the light emitting device under control of the scan signal line and the light emitting signal line. The light emitting unit may at least include a light emitting device, the light emitting device is connected with a pixel drive circuit of a sub-pixel where the light emitting device is located respectively, and the light emitting device is configured to emit light with a corresponding brightness in response to a current output by the pixel drive circuit of the sub-pixel where the light emitting device is located.

In an exemplary implementation, the display device may include a wearable device or a cell phone. Wearable devices may include a hand-supported watch type (e.g., wristband products such as watches and bracelets), a foot-supported shoe type (such as shoes, socks or other leg-wearing products), a head-supported glass type (such as glasses, helmets or headbands), and smart clothing, schoolbags, crutches, accessories, etc. In an embodiment of the present application, a smart watch is taken as an example.

In an exemplary implementation, the display device includes a display area 100 with a circular shape. In some embodiments, the display area 100 may also have a rectangular shape, an elliptical shape, or a polygonal shape such as a triangle and a pentagon.

In an exemplary implementation, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light. In an exemplary implementation, a sub-pixel may be in a shape of a rectangle, a rhombus, a pentagon, or a hexagon. Three sub-pixels may be arranged side by side horizontally, side by side vertically, or in a delta-shaped arrangement, etc., which is not limited here in the present disclosure.

In an exemplary implementation, a pixel unit may include four sub-pixels, and the four sub-pixels may be arranged side by side horizontally, side by side vertically, or in a square, which is not limited here in the present disclosure.

In an exemplary implementation, the light emitting device may include one of an organic light emitting diode (OLED), a light emitting diode (LED), a quantum dot light emitting diode (QLED). The sub-pixel may emit light, such as red light, green light, blue light or white light, by the light emitting device.

FIG. 3 is a schematic diagram of a sectional structure of a display device according to an embodiment of the present application, and FIG. 3 is a sectional view taken along a a-a' direction in FIG. 2. FIG. 3 illustrates structures of three sub-pixels in the display device. In an exemplary implementation, the display device according to the embodiment of the present disclosure may include more sub-pixels (see FIG. 1). In addition, although the three sub-pixels are shown to be adjacent to each other in FIG. 3, the embodiments of the present disclosure are not limited thereto. That is, other assemblies, for example wirings, may be between the three sub-pixels. The three sub-pixels may not be pixels adjacent to each other. In FIG. 3, sections of the three sub-pixels may not be sections in a same direction of the display device.

In an exemplary implementation, as shown in FIG. 3, on a plane perpendicular to the display device, the display area of the display device may include a display substrate, a polarizer 21 provided on a light emitting side of the display substrate, an optical adhesive layer 22 provided on a side of the polarizer 21 away from the display substrate, and a cover plate 23 provided on a side of the optical adhesive layer 22 away from the display substrate. The polarizer 21 is connected with the cover plate 23 through the optical adhesive layer 22.

In an exemplary implementation, the display substrate may include a drive circuit layer 102 provided on a base substrate 101, a light emitting structure layer 103 provided on a side of the drive circuit layer 102 away from the base substrate 101, and an encapsulation structure layer 104 provided on a side of the light emitting structure layer 103 away from the base substrate 101. In some possible implementations, the display device may include another film layer, such as a touch structure layer, which is not limited here in the present disclosure.

In an exemplary implementation, the base substrate 101 may be a flexible base substrate, or may be a rigid base substrate. The drive circuit layer 102 may include multiple circuit units, a circuit unit may at least include a pixel drive circuit, and the pixel drive circuit may include multiple transistors and storage capacitors. The light emitting structure layer 103 may include multiple light emitting units, a light emitting unit may at least include a light emitting device, the light emitting device may include an anode, an organic light emitting layer, and a cathode. The anode is connected with a pixel drive circuit. The organic light emitting layer is connected with the anode. The cathode is connected with the organic light emitting layer. The organic light emitting layer emits light with a corresponding color under driving of the anode and the cathode. The encapsulation layer 104 may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is arranged between the first encapsulation layer and the third encapsulation layer to form a stacked structure of inorganic material/organic material/inorganic material, to ensure that external moisture cannot enter the light emitting structure layer 103.

In an exemplary implementation, the organic light emitting layer may include a light emitting layer (EML), and any one or more of following layers: a hole injection layer (HIL), a hole transport layer (HTL), an electron block layer (EBL), a hole block layer (HBL), an electron transport layer (ETL), and an electron injection layer (EIL).

In some exemplary embodiments, the encapsulation structure layer 104 may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is disposed between the first encapsulation layer and the third encapsulation layer to form a stacked structure of inorganic material/organic material/inorganic material, which may ensure that external moisture cannot enter the light emitting structure layer.

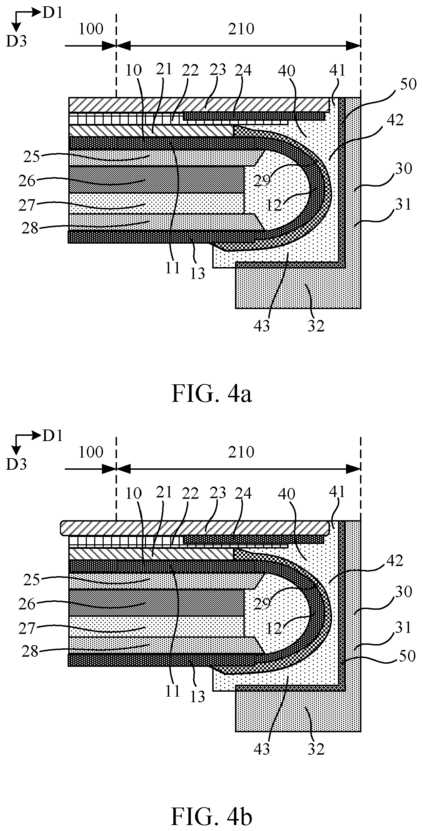

FIG. 4a is a schematic diagram of a sectional structure of a display device according to an embodiment of the present application, and FIG. 4a is a sectional view taken along a b-b' direction in FIG. 2. In an exemplary implementation, as shown in FIG. 4a, on a plane perpendicular to the display device, the bonding area of the display device may include a display substrate 10, a polarizer 21 provided on a light emitting side of the display substrate 10, an optical adhesive layer 22 provided on a side of the polarizer 21 away from the display substrate 10, a light shield layer 24 provided on a side of the optical adhesive layer 22 away from the display substrate 10, and a cover plate 23 provided on a side of the light shield layer 24 away from the display substrate. The light emitting side is a side where the display area of the display substrate displays an image.

In an exemplary implementation, the cover plate 23 may be made of a transparent material, such as glass.

In an exemplary implementation, a light shield layer 24 is positioned between the display substrate 10 and the cover plate 23, an orthographic projection of the light shield layer 24 on a plane of the display device is overlapped with an orthographic projection of an edge area of the cover plate 23 on the plane of the display device, and the light shield layer 24 is configured to shield light to prevent light from leaking from the edge area of the cover plate 23.

In an exemplary implementation, a display device in an embodiment of the present application adopts an outward bending design to bend a portion of the display substrate to a backlight side of the display substrate, so that a size of the bezel area of the display device can be reduced and a narrow bezel can be achieved. The backlight side is a side where the display area of the display substrate does not display an image.

In an exemplary implementation, the display substrate includes a first fixation region 11, a bending region 12, and a second fixation region 13 provided continuously. The bending region 12 is provided between the first fixation region 11 and the second fixation region 13, and the bending region 12 has a C-shaped bending shape. A first end of the bending region 12 is connected with the first fixation region 11, and a second end of the bending region 12 is connected with the second fixation region 13. The first fixation region 11 and the second fixation region 13 are both flat. The second fixation region 13 is provided on a backlight side of the first fixation region 11 through the bending region 12. A portion of the second fixation region 13 is located in the bonding area 210 of the display device, and a portion of the second fixation region 13 is located in the display area 100 of the display device.

In an exemplary implementation, on a plane perpendicular to the display device, the display substrate 10 may further include a support structure layer provided between the first fixation region 11 and the second fixation region 13. A first surface of the support structure layer is connected with the backlight side of the first fixation region 11, and a second surface of the support structure layer is connected with a surface of the second fixation region 13.

In an exemplary implementation, the support structure layer includes a first back plate 25, a super clean foam (SCF) composite film 26, a buffer layer 27, and a second back plate 28. The first back plate 25 is connected with the backlight side of the first fixation region 11 of the display substrate 10. The super clean foam composite film 26 is provided on a side of the first back plate 25 away from the first fixation region 11. The buffer layer 27 is disposed on a side of the super clean foam composite film 26 away from the first fixation region 11. The second back plate 28 is disposed on a side of the buffer layer 27 away from the first fixation region 11, and the second back plate 28 is connected with the surface of the second fixation region 13.

In an exemplary implementation, the super clean foam composite film 26 can buffer a stress acting on the display substrate and dissipate heat generated during operation of the display substrate, thus providing a certain protective effect on the display substrate.

In an exemplary implementation, on a plane perpendicular to the display device, the display substrate 10 may further include a cover layer 29, at least a portion of the cover plate 29 is provided on a surface of the bending region 12 away from the support structure layer, the cover layer 29 has a C-shaped bending shape, and a shape of the cover layer 29 is substantially the same as a shape of the bending region 12. A first end of the cover layer 29 may cover the first fixation region 11 and a second end of the cover layer 29 may cover the second fixation region 13. In an example, the cover layer 29 may be an MCL (Metal Cover Layer) adhesive layer.

In an exemplary implementation, on a plane perpendicular to the display device, the bonding area of the display device may further include a middle bezel 30, the middle bezel 30 is L-shaped, and the middle bezel 30 includes a side bezel 31 and a bottom bezel 32 connected with each other. The side bezel 31 is at least positioned at peripheral sides of the cover plate 23 and the display substrate 10. A first end of the side bezel 31 is perpendicularly connected with a first end of the bottom bezel 32, a second end of the side bezel 31 extends in a direction opposite to a third direction D3, and an end face of the second end of the side bezel 31 is substantially flush with a surface of the cover plate 23 away from the display substrate 10. The bottom bezel 32 is on a side of the second fixation region 13 and the bending region 12 of the display substrate away from the cover plate 23. The first end of the bottom bezel 32 is perpendicularly connected with the first end of the side bezel 31, and a second end of the bottom bezel 32 extends in a direction opposite to a first direction D1. The first direction D1 is a direction parallel to the plane where the display device is located, and the third direction D3 is a direction perpendicular to the plane where the display device is located.

In an exemplary implementation, an orthographic projection of the side bezel 31 of the middle bezel 30 on the plane where the display device is located is not overlapped with an orthographic projection of the cover plate 23 on the plane where the display device is located, a first interval is provided between the side bezel 31 of the middle bezel 30 and the peripheral side face of the cover plate 23, and the first interval can accommodate a first injection molded edge sealing part of the injection molded edge sealing member.

In an exemplary implementation, an orthographic projection of the bottom bezel 32 of the middle bezel 30 on the plane where the display device is located is overlapped with both of an orthographic projection of an edge area of the display substrate 10 and an orthographic projection of the edge area of the cover plate 23 on the plane where the display device is located. A second interval is provided between the bottom bezel 32 and the display substrate 10, and the second interval can accommodate a third injection molded edge sealing part of the injection molded edge sealing member.

In an exemplary implementation, on a plane perpendicular to the display device, the bonding area of the display device may further include an injection molded edge sealing member 40. The injection molded edge sealing member 40 includes a first injection molded edge sealing part 41, a second injection molded edge sealing part 42, and a third injection molded edge sealing part 43 provided sequentially along the third direction D3. At least a portion of the first injection molded edge sealing part 41 is provided between the peripheral side face of the cover plate 23 and the side bezel 31 of the middle bezel 30, at least a portion of the second injection molded edge sealing part 42 is provided between the peripheral side face of the display substrate 10 and the side bezel 31 of the middle bezel 30, and at least a portion of the third injection molded edge sealing part 43 is provided between the edge area of the display substrate 10 and the bottom bezel 32 of the middle bezel 30.

The display device of the embodiment of the present disclosure can adopt an edge injection molding (Insert Molding) technology to seal a gap between the peripheral side faces of the cover plate 23 and the display substrate 10 and the middle bezel 30 by the injection molded edge sealing member 40. The injection molded edge sealing member 40 can absorb light leaked from the gap between a peripheral side face of the light shield layer 24 and the peripheral side face of the cover plate 23, solve the problem of light leakage at the edge of the display device, and reduce a size of the bezel of the display device to achieve a narrow bezel.

In an exemplary implementation, the first injection molded edge sealing part 41 is provided between the peripheral side faces of the cover plate 23 and the light shield layer 24 and the side bezel 31 of the middle bezel 30. An orthographic projection of the first injection molded edge sealing part 41 on the plane where the display device is located is not overlapped with orthographic projections of the cover plate 23 and the light shield layer 24 on the plane where the display device is located. The first injection molded edge sealing part 41 fills the gap between the peripheral side faces of the cover plate 23 and the light shield layer 24 and the side bezel 31 of the middle bezel 30 for absorbing light, preventing light emitted from the display area from being diffusely reflected at the gap between the peripheral side face of the cover plate 23 and the side bezel 31 of the middle bezel 30, and achieving the purpose of preventing light leakage.

In an exemplary implementation, the first injection molded edge sealing part 41 is located on a side of the second injection molded edge sealing part 42 away from the bottom bezel 32. A first end of the first injection molded edge sealing part 41 is connected with a first end of the second injection molded edge sealing part 42. A second end of the first injection molded edge sealing part 41 extends in a direction opposite to the third direction D3, and an end face of the second end of the first injection molded edge sealing part 41 is substantially flush with the surface of the cover plate 23 away from the display substrate 10. The first end and the second end of the first injection molded edge sealing part 41 are two opposite ends of the first injection molded edge sealing part 41 in the third direction D3, respectively.

In an exemplary implementation, a first side face of the first injection molded edge sealing part 41 is connected with the peripheral side faces of the cover plate 23 and the light shield layer 24, and a second side face of the first injection molded edge sealing part 41 is connected with the side bezel 31 of the middle bezel 30. The first side face and the second side face of the first injection molded edge sealing part 41 are two opposite side faces of the first injection molded edge sealing part 41 in the first direction D1, respectively.

In an exemplary implementation, the first end of the second injection molded edge sealing part 42 is connected with the first end of the first injection molded edge sealing part 41, a second end of the second injection molded edge sealing part 42 extends in the third direction D3, and the second end of the second injection molded edge sealing part 42 is connected with a first end of the third injection molded edge sealing part 43. The first end and the second end of the second injection molded edge sealing part 42 are two opposite ends of the second injection molded edge sealing part 42 in the third direction D3, respectively.

In an exemplary implementation, a portion of the second injection molded edge sealing part 42 is provided in a cavity formed between the bending region 12 of the display substrate 10 and a peripheral side face of the support structure layer, and the cavity is filled. A portion of the second injection molded edge sealing part 42 is provided between a peripheral side face of the bending region 12 of the display substrate 10 and the side bezel 31 of the middle bezel 30.

In an exemplary implementation, an orthographic projection of the second injection molded edge sealing part 42 on the plane where the display device is located is overlapped with orthographic projections of the edge area of the display substrate 10 and the edge area of the cover plate 23 on the plane where the display device is located.

In an exemplary implementation, a first end of a portion of the third injection molded edge sealing part 43 is connected with the second end of the second injection molded edge sealing part 42. A first end of a portion of the third injection molded edge sealing part 43 is connected with the cover layer 29 on the second fixation region 13 and the bending region 12. A second end of the third injection molded edge sealing part 43 extends along the third direction D3, and the second end of the third injection molded edge sealing part 43 is connected with the bottom bezel 32 of the middle bezel 30. The first end and the second end of the third injection molded edge sealing part 43 are two opposite ends of the third injection molded edge sealing part 43 in the third direction D3, respectively.

In an exemplary implementation, the first injection molded edge sealing part 41, the second injection molded edge sealing part 42, and the third injection molded edge sealing part 43 are of an integral structure and include a same material, i.e. the first injection molded edge sealing part 41, the second injection molded edge sealing part 42, and the third injection molded edge sealing part 43 may be manufactured using the same material by a same injection mold process.

In an exemplary implementation, a material of the injection molded edge sealing member 40 may include epoxy resin, and the materials of the first injection molded edge sealing part 41, the second injection molded edge sealing part 42, and the third injection molded edge sealing part 43 may all include epoxy resin.

In an exemplary implementation, the bonding area of the display device may further include a sealant layer 50, a shape of the sealant layer 50 is L-shaped, and the sealant layer 50 is provided between the injection molded edge sealing member 40 and the side bezel 31 and the bottom bezel 32 of the middle bezel 30.

In an exemplary implementation, a width of the sealant layer 50 in the first direction D1 is greater than or equal to 0.05 mm and less than or equal to 1mm.

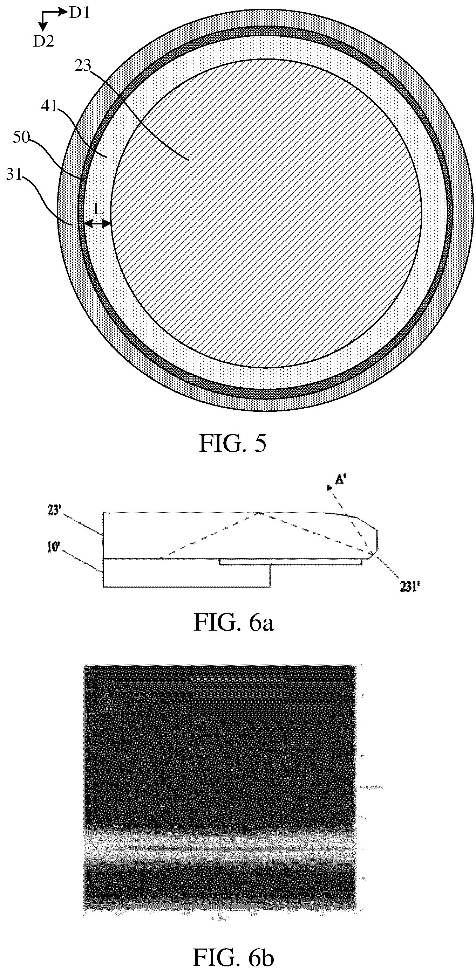

FIG. 5 is a schematic diagram of a planar structure of a first injection molded edge sealing part of a display device according to an embodiment of the present application. In an exemplary implementation, as shown in FIG. 5, on a plane parallel to the display device, a shape of the cover plate 23 includes a circular shape, a shape of the first injection molded edge sealing part 41 includes an annulus shape, and a shape of the side bezel 31 of the middle bezel 30 includes an annulus shape. The first injection molded edge sealing part 41 is provided around a periphery of the cover plate 23 and is located between the peripheral side face of the cover plate 23 and the side bezel 31 of the middle bezel 30.

In an exemplary implementation, a width L of the annulus of the first injection molded edge sealing part 41 is greater than or equal to 0.05 mm and less than or equal to 1mm, for example, the width L of the annulus is greater than or equal to 0.15 mm and less than or equal to 0.3 mm.

FIG. 6a is a schematic diagram of a sectional structure of a cover plate in a display device. As shown in FIG. 6a, a chamfer 231' is provided at a corner position of an edge of the cover plate 23' of the display device.

According to a research from the inventors of the present application, light A' emitted from the display substrate 10' will be reflected at the chamfer 231' of the cover plate 23', so that the light A' is emitted towards the light emitting side of the display substrate 10', resulting in light leakage of the display device.

FIG. 6b is a simulation diagram of light leakage of the display device in FIG. 6a. A light leakage simulation test is made for the cover plate of the display device shown in FIG. 6a and light leakage occurs at an edge area of the cover plate in the display device, as shown in FIG. 6b.

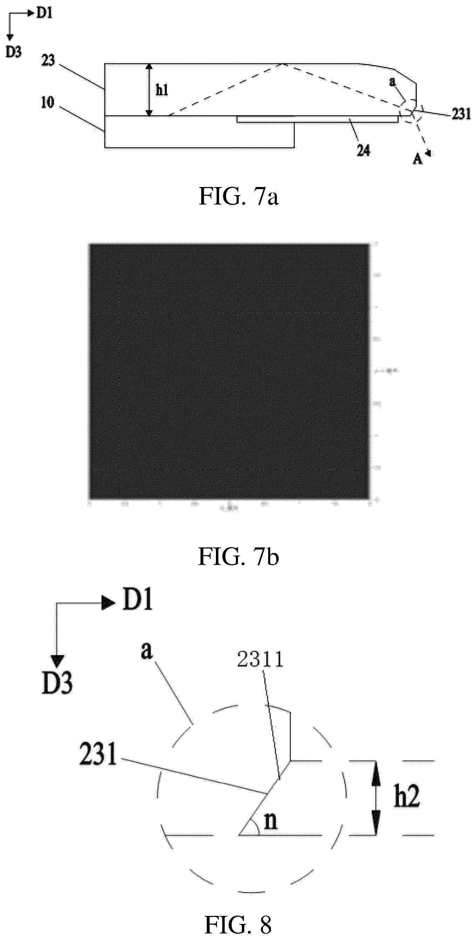

FIG. 4b is a schematic diagram of a sectional structure of another display device according to an embodiment of the present application, and FIG. 7a is a schematic diagram of a sectional structure of a cover plate in a display device according to an embodiment of the present application. In an exemplary implementation, as shown in FIG. 4b and FIG. 7a, on a plane perpendicular to the display device, a shape of the cover plate 23 in the display device of an embodiment of the present application includes a rectangle, a chamfer 231 is provided at a corner position of an edge area of the cover plate 23, and the chamfer 231 is located on a side of the cover plate 23 close to the display substrate 10.

In an exemplary implementation, an orthographic projection of the light shield layer 24 on the plane where the display device is overlapped with an orthographic projection of the edge area of the cover plate 23 on the plane where the display device is located, and due to a tolerance in the preparation process of the light shield layer 24, a peripheral side face of the light shield layer 24 retracts inwardly relative to a peripheral side face of the cover plate 23.

FIG. 8 is an enlarged view of a chamfer of a cover plate in a display device according to an embodiment of the present application, and FIG. 8 is an enlarged view of part a in FIG. 7a. In an exemplary implementation, as shown in FIG. 7a and FIG. 8, the cover plate 23 has a maximum thickness h1, and the maximum thickness h1 is a maximum distance between a surface of the cover plate 23 away from the display substrate and a surface of the cover plate 23 close to the display substrate. The chamfer 231 has a height h2 in a thickness direction (third direction D3) of the cover plate 23, a ratio of the height h2 of the chamfer 231 to the maximum thickness h1 of the cover plate 23 is greater than or equal to 0.03 and less than or equal to 0.5, and for example, the ratio of the height h2 of the chamfer 231 to the maximum thickness h1 of the cover plate 23 is greater than or equal to 0.04 and less than or equal to 0.4. Further, the ratio of the height h2 of the chamfer 231 to the maximum thickness h1 of the cover plate 23 is greater than or equal to 0.1 and less than or equal to 0.2.

The cover plate 23 of the display device according to the embodiment of the present disclosure has the chamfer 231 with the aforementioned height h2, so that light A is reflected at the chamfer 231 of the cover plate 23 and emits toward the backlight side of the display substrate 10, thereby preventing light leakage at the edge of the display device. In addition, the chamfer 231 with the aforementioned height h2 can reflect light leaked from a gap between a peripheral side face of the light shield layer 24 and a peripheral side face of the cover plate 23 toward the backlight side of the display substrate 10, thereby solving the problem of light leakage at the edge of the display device.

In an exemplary implementation, the chamfer 231 of the cover plate 23 has a bevel edge 2311, an included angle n between the bevel edge 2311 and the plane where the display device is located is greater than or equal to 50 degrees and less than or equal to 80 degrees. For example, the included angle n is greater than or equal to 60 degrees and less than or equal to 70 degrees.

The cover plate 23 of the display device according to an embodiment of the present disclosure has the chamfer 231 with the aforementioned included angle n, so that light A is reflected at the chamfer 231 of the cover plate 23 and emits toward the backlight side of the display substrate 10, thereby preventing light leakage at the edge of the display device. In addition, the chamfer 231 with the aforementioned included angle n can reflect light leaked from the gap between the peripheral side face of the light shield layer 24 and the peripheral side face of the cover plate 23 toward the backlight side of the display substrate 10, thereby solving the problem of light leakage at the edge of the display device.

FIG. 7b is a simulation diagram of light leakage of the display device in FIG. 7a. A light leakage simulation test is made for the cover plate of the display device shown in FIG. 7a and no light leakage occurs in the edge area of the cover plate in the display device, as shown in FIG. 7b.

An embodiment of the present application provides an injection mold, the injection mold may be used for performing injection molding on the display substrate and the cover plate of the display device shown in FIG. 4a, to form an injection molded edge sealing member.

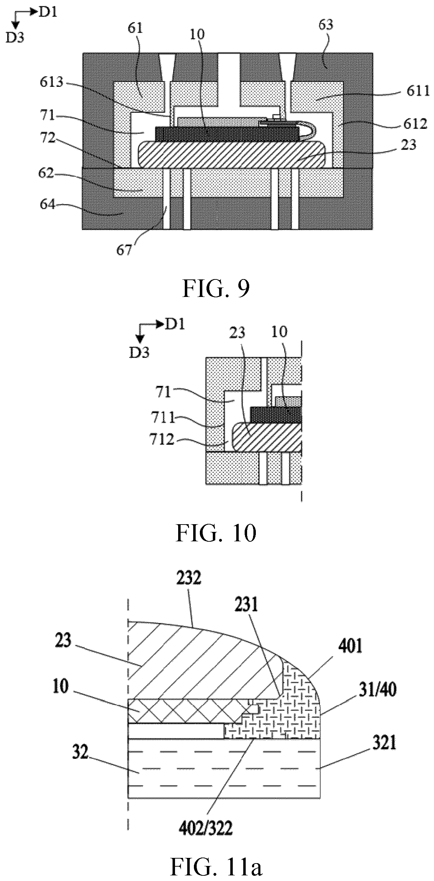

FIG. 9 is a schematic diagram of a sectional structure of an injection mold according to an embodiment of the present application. In an exemplary implementation, as shown in FIG. 9, on a plane perpendicular to the injection mold, the injection mold includes an upper mold core 61 and a lower mold core 62. The upper mold core 61 and the lower mold core 62 are configured to enclose the display substrate 10 and the cover plate 23 of the aforementioned display device to form an injection mold cavity 71 connected with edge areas of the display substrate 10 and the cover plate 23, and the injection mold cavity 71 is configured to accommodate an injection mold fluid for forming an injection molded edge sealing member.

In an exemplary implementation, a shape of the upper mold core 61 includes an inverted U-shape. The upper mold core 61 includes a bottom wall 611 and a side wall 612, the bottom wall 611 of the upper mold core 61 is plate-shaped, and the side wall 612 of the upper mold core 61 is annular-shaped. A first end of the side wall 612 is connected perpendicularly to an edge of the bottom wall 611, a second end of the side wall 612 extends long the third direction D3, and the second end of the side wall 612 is connected perpendicularly to an edge of the lower mold core 62.

In an exemplary implementation, the upper mold core 61 further includes a retaining wall 613 provided on the bottom wall 611, and the retaining wall 613 is annular-shaped. A first end of the retaining wall 613 is connected with the bottom wall 611, and a second end of the retaining wall 613 is connected with a surface of the display substrate 10 away from the cover plate 23. The retaining wall 613, the bottom wall 611, the side wall 612 of the upper mold core 61 and the lower mold core 62 form the injection mold cavity 71.

In an exemplary implementation, the bottom wall 611, the side wall 612, and the retaining wall 613 of the upper mold core 61 may be connected as a whole and include a same material.

In an exemplary implementation, the lower mold core 62 is plate-shaped, and a surface of the lower mold core 62 close to the upper mold core 61 is planar. An edge of the surface of the lower mold core 62 close to the upper mold core 61 is connected perpendicularly to the second end of the side wall 612 of the upper mold core 61.

In an exemplary implementation, a junction between the lower mold core 62 and the upper mold core 61 is a mold closing line 72, and the mold closing line 72 is substantially flush with the surface of the cover plate 23 away from the display substrate 10.

In an exemplary implementation, the upper mold core 61 may be made of a flexible material, such as silica gel. The lower mold core 62 may be made of a high molecular polymer, such as polytetrafluoroethylene.

In an exemplary implementation, the injection mold further includes an upper mold base 63 and a lower mold base 64. A shape of the upper mold base 63 includes an inverted U shape, the upper mold base 63 covers a side of the upper mold core 61 away from the lower mold core 62, and the upper mold base 63 is connected with a surface of the upper mold core 61 away from the lower mold core 62. A shape of the lower mold base 64 includes a U shape, the lower mold base 64 covers a side of the lower mold core 62 away from the upper mold core 61, and the lower mold base 64 is connected with a surface of the lower mold core 62 away from the upper mold core 61.

The upper mold base 63 and the lower mold base 64 of the injection mold according to the embodiment of the present application can support the upper mold core 61 and the lower mold core 62.

In an exemplary implementation, both the upper mold base 63 and the lower mold base 64 may be made of a metallic material, such as stainless steel.

In an exemplary implementation, the injection mold further includes an inlet hole 65 and an outlet hole 66, both of the inlet hole 65 and the outlet hole 66 are provided in the upper mold base 63 and the upper mold core 61, and both of the inlet hole 65 and the outlet hole 66 penetrate the upper mold base 63 and the upper mold core 61 and communicate with the injection mold cavity 71. The inlet hole 65 and the outlet hole 66 are used to achieve flowing of the injection mold fluid in the injection mold cavity 71, so that the injection mold fluid can fill the injection mold cavity 71.

In an exemplary implementation, the injection mold further includes a degassing hole 67, the degassing hole 67 is provided in the lower mold base 64 and the lower mold core 62, and the degassing hole 67 penetrates the lower mold base 64 and the lower mold core 62 to be connected with a surface of the cover plate 23 away from the display substrate 10. The degassing hole 67 is used for connection with a suction platform, and the suction platform adsorbs and fixes the cover plate 23 in the injection mold through the degassing hole 67, so as to prevent the cover plate 23 and the display substrate 10 from shifting and ensure accuracy of injection mold.

FIG. 10 is an enlarged view of an injection mold according to an embodiment of the present application. In an exemplary implementation, as shown in FIG. 10, on a plane perpendicular to the injection mold, the injection mold cavity 71 includes an inner side face 711. At least a portion of the inner side face 711 of the injection mold cavity 71 is located outside the peripheral side face of the cover plate 23. A gap 712 is formed between the inner side face 711 of the injection mold cavity 71 and the peripheral side face of the cover plate 23, the gap 712 may accommodate an injection mold fluid for forming an injection molded edge sealing member, and the injection mold fluid in the gap 712 may form a first injection molded edge sealing part of the injection molded edge sealing member.

In an exemplary implementation, a spacing of the gap 712 in the first direction D1 may be greater than or equal to 0.05 mm and less than or equal to 1mm, for example, the spacing of the gap 712 in the first direction D1 is greater than or equal to 0.15 mm and less than or equal to 0.3 mm.

FIG. 11a is a schematic diagram of a sectional structure of a cover plate and an injection molded edge sealing member of a display device according to an embodiment of the present application. In an exemplary implementation, as shown in FIG. 11a, the structure of the display device of this exemplary embodiment is substantially the same as that of the embodiment shown in FIG. 4a, except that the injection molded edge sealing member 40 in the display device of this exemplary embodiment and the side bezel 31 of the middle bezel 30 are connected as a whole and include a same material, i.e. the injection molded edge sealing member 40 of the display device serves as the side bezel 31 of the middle bezel 30, and the injection molded edge sealing member 40 is provided on the bottom bezel 32. The injection molded edge sealing member 40 is on the peripheral sides of the cover plate 23 and the display substrate 10.

**In** an exemplary implementation, a light shield layer (not shown in the figure) is provided between the cover plate 23 and the display substrate 10 in the display device of this exemplary embodiment, and the light shield layer is substantially the same as the light shield layer shown in FIG. 4a, which will not be repeated here in the embodiments of the present application..

**In** an exemplary implementation, in the display device of this exemplary embodiment, the cover plate 23 is provided with a chamfer (not shown in the figure) and the structure of the chamfer is substantially the same as the structure of the chamfer shown in FIG. 7, which will not be repeated here in the embodiments of the present application.

In an exemplary implementation, the cover plate 23 includes an outer surface 232, and the outer surface is a surface of the cover plate 23 away from the display substrate 10. An edge area of the outer surface 232 of the cover plate 23 is arc-shaped.

In an exemplary implementation, the bottom bezel 32 of the middle bezel 30 includes a second side surface 321, and the second side surface 321 of the bottom bezel 32 is planar.

In an exemplary implementation, the injection molded edge sealing member 40 includes a first side surface 401 and a bottom surface 402. The first side surface 401 is a side surface of the injection molded edge sealing member 40 away from the peripheral side faces of the cover plate 23 and the display substrate 10, and the bottom surface 402 is a surface of the injection molded edge sealing member 40 close to the bottom bezel 32 of the middle bezel 30. A first end of the first side surface 401 is connected with the outer surface 232 of the cover plate 23, and a second end of the first side surface 401 is connected with the second side surface 321 of the bottom bezel 32 of the middle bezel 30.

In an exemplary implementation, the first side surface 401 of the injection molded edge sealing member 40 is connected with the edge area of the outer surface 232 of the cover plate 23 to form an arc surface.

In an exemplary implementation, the bottom surface 402 of the injection molded edge sealing member 40 is planar.

In an exemplary implementation, the bottom bezel 32 of the middle bezel 30 has an upper surface 322 on a side close to the injection molded edge sealing member 40, the upper surface is planar, and the bottom surface 402 of the injection molded edge sealing member 40 is connected with the upper surface 322 of the bottom bezel 32.

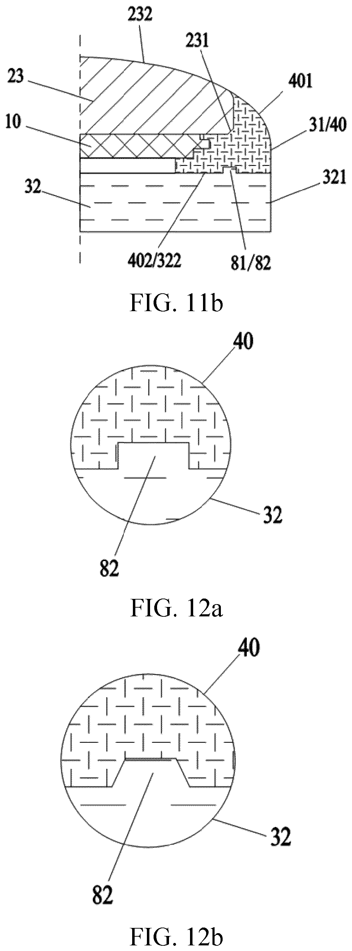

FIG. 11b is a schematic diagram of a sectional structure of a cover plate and an injection molded edge sealing member of another display device according to an embodiment of the present application. In an exemplary implementation, as shown in FIG. 11b, the structure of the display device of this exemplary embodiment is substantially the same as that of the embodiment shown in FIG. 11a except that, the bottom surface 402 of the injection molded edge sealing member 40 is provided with a first positioning clamp groove 81. The first positioning clamp groove 81 is in a middle area of the bottom surface 402 of the injection molded edge sealing member 40. The upper surface 322 of the bottom bezel 32 of the middle bezel 30 is provided with a first positioning protrusion 82 and the first positioning protrusion 82 is in a middle area of the upper surface 322 of the bottom bezel 32. The first positioning protrusion 82 is engaged with the first positioning clamp groove 81, so that the injection molded edge sealing member 40 is fixed on the bottom bezel 32 of the middle bezel 30.

In an exemplary implementation, in the display device of this exemplary embodiment, a light shield layer (not shown in the figure) is provided between the cover plate 23 and the display substrate 10 and the light shield layer is substantially the same as the light shield layer shown in FIG. 4a, which will not be repeated here in the embodiments of the present application..

In an exemplary implementation, in the display device of this exemplary embodiment, the cover plate 23 is provided with a chamfer (not shown in the figure) and the structure of the chamfer is substantially the same as the structure of the chamfer shown in FIG. 7a, which will not be repeated here in the embodiments of the present application.

FIG. 12a is an enlarged view of a first positioning clamp groove and a first positioning protrusion of a display device according to an embodiment of the present application. **In an** exemplary implementation, as shown in FIG. 12a, on a plane perpendicular to the display device, a shape of the first positioning protrusion 82 includes a rectangle and the first positioning protrusion 82 is in a middle area of the bottom bezel 32 of the middle bezel 30. A shape of the first positioning clamp groove 81 includes a rectangle and the first positioning clamp groove 81 is in a middle area of the bottom surface 402 of the injection molded edge sealing member 40. A size of the first positioning protrusion 82 is matched with a size of the first positioning clamp groove 81, so that the first positioning protrusion 82 can be engaged with the first positioning clamp groove 81.

FIG. 12b is an enlarged view of a first positioning clamp groove and a first positioning protrusion of another display device according to an embodiment of the present application. In an exemplary implementation, as shown in FIG. 12b, on a plane perpendicular to the display device, a shape of the first positioning protrusion 82 includes a trapezoid and the first positioning protrusion 82 is in the middle area of the bottom bezel 32 of the middle bezel 30. A shape of the first positioning clamp groove 81 includes a trapezoid and the first positioning clamp groove 81 is in the middle area of the bottom surface 402 of the injection molded edge sealing member 40. A size of the first positioning protrusion 82 is matched with a size of the first positioning clamp groove 81, so that the first positioning protrusion 82 can be engaged with the first positioning clamp groove 81.

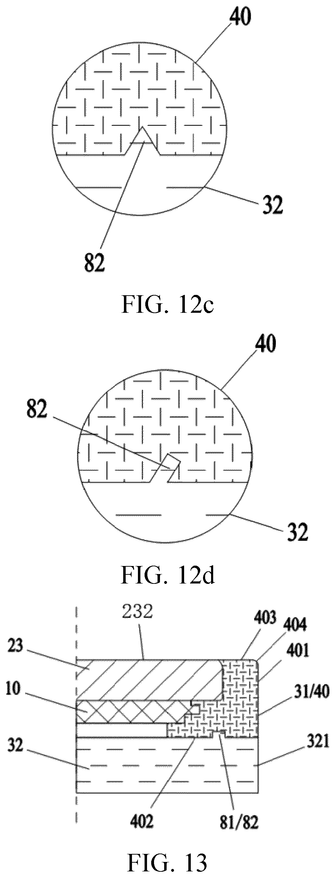

FIG. 12c is an enlarged view of a first positioning clamp groove and a first positioning protrusion of another display device according to an embodiment of the present application. In an exemplary implementation, as shown in FIG. 12c, on a plane perpendicular to the display device, a shape of the first positioning protrusion 82 includes a triangle and the first positioning protrusion 82 is in the middle area of the bottom bezel 32 of the middle bezel 30. A shape of the first positioning clamp groove 81 includes a triangle and the first positioning clamp groove 81 is in the middle area of the bottom surface 402 of the injection molded edge sealing member 40. A size of the first positioning protrusion 82 is matched with a size of the first positioning clamp groove 81, so that the first positioning protrusion 82 can be engaged with the first positioning clamp groove 81.

FIG. 12d is an enlarged view of a first positioning clamp groove and a first positioning protrusion of another display device according to an embodiment of the present application. In an exemplary implementation, as shown in FIG. 12d, on a plane perpendicular to the display device, a shape of the first positioning protrusion 82 includes an elongated strip, a central axis of the first positioning protrusion 82 forms an acute angle with the plane where the display device is located, and the first positioning protrusion 82 is in the middle area of the bottom bezel 32 of the middle bezel 30. A shape of the first positioning clamp groove 81 includes an elongated strip, a central axis of the first positioning clamp groove 81 forms an acute angle with the plane where the display device is located, and the first positioning clamp groove 81 is in the middle area of the bottom surface 402 of the injection molded edge sealing member 40. A size of the first positioning protrusion 82 is matched with a size of the first positioning clamp groove 81, so that the first positioning protrusion 82 can be engaged with the first positioning clamp groove 81.

FIG. 13 is a schematic diagram of a sectional structure of a cover plate and an injection molded edge sealing member of another display device according to an embodiment of the present application. In an exemplary implementation, as shown in FIG. 13, the structure of the display device of this exemplary embodiment is substantially the same as that of the embodiment shown in FIG. 11b except that, the injection molded edge sealing member 40 includes a top surface 403, a first side surface 401, a bottom surface 402 and a filleted corner 404 in a display device of this exemplary embodiment. The top surface 403 is a surface of the injection molded edge sealing member 40 away from the bottom bezel. The first side surface 401 is a surface of the injection molded edge sealing member 40 on a side away from the peripheral side faces of the cover plate 23 and the display substrate 10. The bottom surface 402 is a surface of the injection molded edge sealing member 40 close to the bottom bezel 32 of the middle bezel 30. The top surface 403 is connected with the first side surface 401 by the filleted corner 404. A first end of the top surface 403 is connected with the outer surface 232 of the cover plate 23, and a second end of the top surface 403 is connected with a first end of the filleted corner 404. A second end of the filleted corner 404 is connected with a first end of the first side surface 401, and a second end of the first side surface 401 is connected with the second side surface 321 of the bottom bezel 32 of the middle bezel 30. As an example, the filleted corner 404 may be 90 degrees.

In an exemplary implementation, the outer surface 232 of the cover plate 23, the top surface 403 of the injection molded edge sealing member 40, the first side surface 401 of the injection molded edge sealing member 40, and the second side surface 321 of the bottom bezel 32 are all planar.

In an exemplary implementation, the outer surface 232 of the cover plate 23 is substantially flush with the top surface 403 of the injection molded edge sealing member 40.

In an exemplary implementation, the first side surface 401 of the injection molded edge sealing member 40 is substantially flush with the second side surface 321 of the bottom bezel 32.

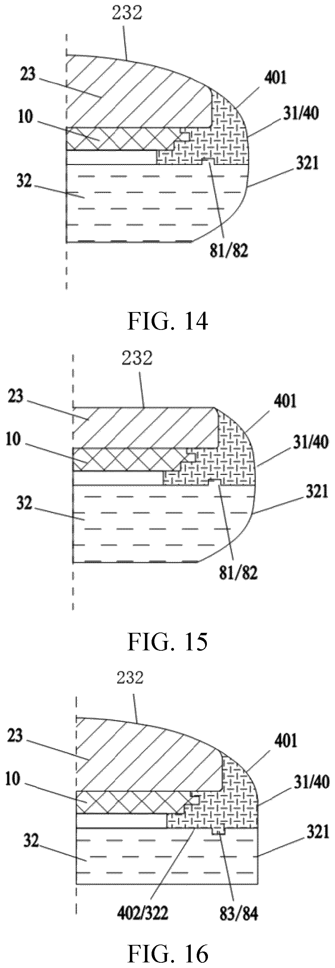

FIG. 14 is a schematic diagram of a sectional structure of a cover plate and an injection molded edge sealing member of another display device according to an embodiment of the present application. In an exemplary implementation, as shown in FIG. 14, the structure of the display device of this exemplary embodiment is substantially the same as that of the embodiment shown in FIG. 11b except that, the second side surface 321 of the bottom bezel 32 of the middle bezel 30 is arc-shaped.

In an exemplary implementation, the first side surface 401 of the injection molded edge sealing member 40 is connected with the edge area of the outer surface 232 of the cover plate 23 to form an arc surface.

In an exemplary implementation, the first side surface 401 of the injection molded edge sealing member 40 is connected with the second side surface 321 of the bottom bezel 32 to form an arc surface.

In an exemplary implementation, the first side surface 401 of the injection molded edge sealing member 40 is in shape of a 1/4 arc and the second side surface 321 of the bottom bezel 32 is in shape of a 1/4 arc.

FIG. 15 is a schematic diagram of a sectional structure of a cover plate and an injection molded edge sealing member of another display device according to an embodiment of the present application. In an exemplary implementation, as shown in FIG. 15, the structure of the display device of this exemplary embodiment is substantially the same as that of the embodiment shown in FIG. 11b except that, the edge area of the outer surface 232 of the cover plate 23 is planar, the first side surface 401 of the injection molded edge sealing member 40 is arc-shaped, and the second side surface 321 of the bottom bezel 32 of the middle bezel 30 is arc-shaped.

In an exemplary implementation, the first side surface 401 of the injection molded edge sealing member 40 is connected with the second side surface 321 of the bottom bezel 32 to form an arc surface.

FIG. 16 is a schematic diagram of a sectional structure of a cover plate and an injection molded edge sealing member of another display device according to an embodiment of the present application. In an exemplary implementation, as shown in FIG. 16, the structure of the display device of this exemplary embodiment is substantially the same as that of the embodiment shown in FIG. 11b except that, the bottom surface 402 of the injection molded edge sealing member 40 is provided with a second positioning protrusion 83 and the second positioning protrusion 83 is in the middle area of the bottom surface 402 of the injection molded edge sealing member 40. The upper surface 322 of the bottom bezel 32 of the middle bezel 30 is provided with a second positioning clamp groove 84 and the second positioning clamp groove 84 is in the middle area of the bottom bezel 32. The second positioning protrusion 83 is engaged with the second positioning clamp groove 84, so that the injection molded edge sealing member 40 is fixed on the bottom bezel 32 of the middle bezel 30.

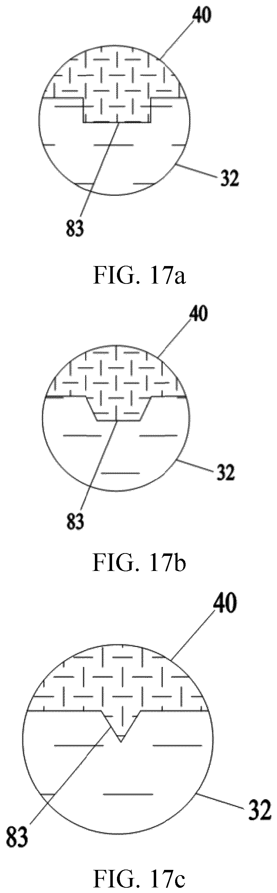

FIG. 17a is an enlarged view of a second positioning clamp groove and a second positioning protrusion of a display device according to an embodiment of the present application. In an exemplary implementation, as shown in FIG. 17a, on a plane perpendicular to the display device, a shape of the second positioning protrusion 83 includes a rectangle and the second positioning protrusion 83 is in the middle area of the bottom surface 402 of the injection molded edge sealing member 40. A shape of the second positioning clamp groove 84 includes a rectangle and the second positioning clamp groove 84 is in the middle area of the bottom bezel 32 of the middle bezel 30. A size of the second positioning protrusion 83 is matched with a size of the second positioning clamp groove 84, so that the second positioning protrusion 83 can be engaged with the second positioning clamp groove 84.

FIG. 17b is an enlarged view of a second positioning clamp groove and a second positioning protrusion of a display device according to an embodiment of the present application. In an exemplary implementation, as shown in FIG. 17b, on a plane perpendicular to the display device, a shape of the second positioning protrusion 83 includes a trapezoid and the second positioning protrusion 83 is in the middle area of the bottom surface 402 of the injection molded edge sealing member 40. A shape of the second positioning clamp groove 84 includes a trapezoid and the second positioning clamp groove 84 is in the middle area of the bottom bezel 32 of the middle bezel 30. A size of the second positioning protrusion 83 is matched with a size of the second positioning clamp groove 84, so that the second positioning protrusion 83 can be engaged with the second positioning clamp groove 84.

FIG. 17c is an enlarged view of a second positioning clamp groove and a second positioning protrusion of a display device according to an embodiment of the present application. In an exemplary implementation, as shown in FIG. 17c, on a plane perpendicular to the display device, a shape of the second positioning protrusion 83 includes a triangle and the second positioning protrusion 83 is in the middle area of the bottom surface 402 of the injection molded edge sealing member 40. A shape of the second positioning clamp groove 84 includes a triangle and the second positioning clamp groove 84 is in the middle area of the bottom bezel 32 of the middle bezel 30. A size of the second positioning protrusion 83 is matched with a size of the second positioning clamp groove 84, so that the second positioning protrusion 83 can be engaged with the second positioning clamp groove 84.

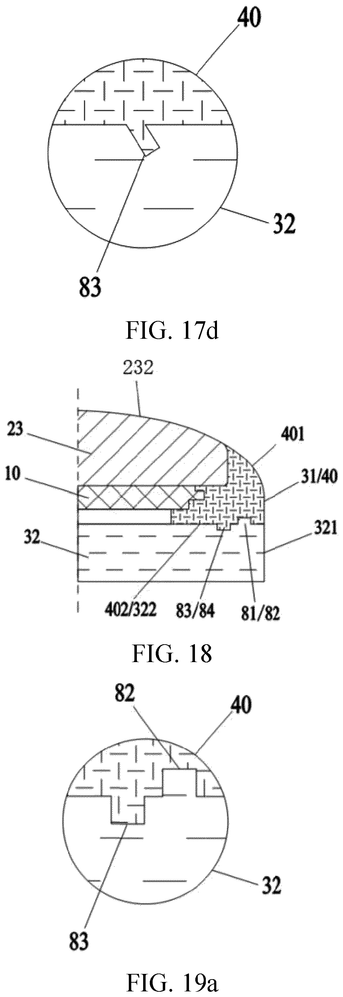

FIG. 17d is an enlarged view of a second positioning clamp groove and a second positioning protrusion of a display device according to an embodiment of the present application. In an exemplary implementation, as shown in FIG. 17d, on a plane perpendicular to the display device, a shape of the second positioning protrusion 83 includes an elongated strip, a central axis of the second positioning protrusion 83 forms an acute angle with the plane where the display device is located, and the second positioning protrusion 83 is in the middle area of the bottom surface 402 of the injection molded edge sealing member 40. A shape of the second positioning clamp groove 84 includes an elongated strip, a central axis of the second positioning clamp groove 84 forms an acute angle with the plane where the display device is located, and the second positioning clamp groove 84 is in the middle area of the bottom bezel 32 of the middle bezel 30. A size of the second positioning protrusion 83 is matched with a size of the second positioning clamp groove 84, so that the second positioning protrusion 83 can be engaged with the second positioning clamp groove 84.

FIG. 18 is a schematic diagram of a sectional structure of a cover plate and an injection molded edge sealing member of another display device according to an embodiment of the present application. In an exemplary implementation, as shown in FIG. 18, the structure of the display device of this exemplary embodiment is substantially the same as that of the embodiment shown in FIG. 11 except that, the bottom surface 402 of the injection molded edge sealing member 40 is provided with a first positioning clamp groove 81 and a second positioning protrusion 83, the upper surface 322 of the bottom bezel 32 of the middle bezel 30 is provided with a first positioning protrusion 82 and a second positioning clamp groove 84, the first positioning protrusion 82 is engaged with the first positioning clamp groove 81, and the second positioning protrusion 83 is engaged with the second positioning clamp groove 84, so that the injection molded edge sealing member 40 is fixed on the bottom bezel 32 of the middle bezel 30.

FIG. 19a is an enlarged view of a junction of an injection molded edge sealing member and a middle bezel of a display device according to an embodiment of the present application. In an exemplary implementation, as shown in FIG. 19a, on a plane perpendicular to the display device, shapes of the first positioning clamp groove 81 and the second positioning protrusion 83 each include a rectangle and the first positioning clamp groove 81 and the second positioning protrusion 83 are both in the middle area of the bottom surface 402 of the injection molded edge sealing member 40. Shapes of the first positioning protrusion 82 and the second positioning clamp groove 84 are each include a rectangle and shapes of the first positioning protrusion 82 and the second positioning clamp groove 84 are both in the middle area of the bottom bezel 32 of the middle bezel 30. A size of the first positioning protrusion 82 is matched with a size of the first positioning clamp groove 81 and a size of the second positioning protrusion 83 is matched with a size of the second positioning clamp groove 84, so that the second positioning protrusion 83 can be engaged with the second positioning clamp groove 84.

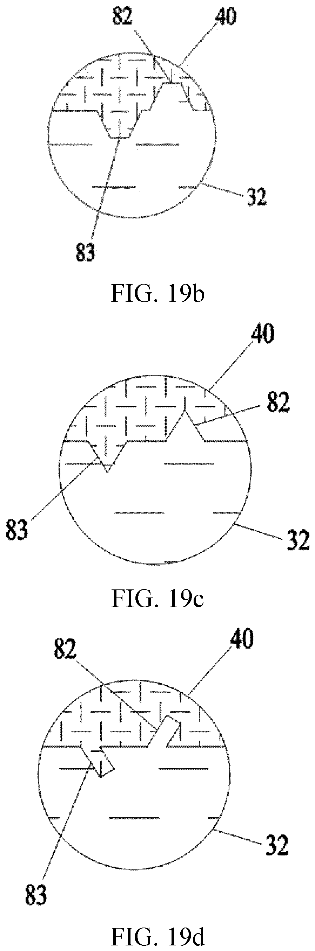

FIG. 19b is an enlarged view of a junction of an injection molded edge sealing member and a middle bezel of another display device according to an embodiment of the present application. In an exemplary implementation, as shown in FIG. 19b, on a plane perpendicular to the display device, shapes of the first positioning clamp groove 81 and the second positioning protrusion 83 each include a trapezoid and the first positioning clamp groove 81 and the second positioning protrusion 83 are both in the middle area of the bottom surface 402 of the injection molded edge sealing member 40. Shapes of the first positioning protrusion 82 and the second positioning clamp groove 84 each include a trapezoid and the first positioning protrusion 82 and the second positioning clamp groove 84 are both in the middle area of the bottom bezel 32 of the middle bezel 30. A size of the first positioning protrusion 82 is matched with a size of the first positioning clamp groove 81 and a size of the second positioning protrusion 83 is matched with a size of the second positioning clamp groove 84, so that the second positioning protrusion 83 can be engaged with the second positioning clamp groove 84.

FIG. 19c is an enlarged view of a junction of an injection molded edge sealing member and a middle bezel of another display device according to an embodiment of the present application. In an exemplary implementation, as shown in FIG. 19c, on a plane perpendicular to the display device, shapes of the first positioning clamp groove 81 and the second positioning protrusion 83 each include a triangle and the first positioning clamp groove 81 and the second positioning protrusion 83 are both in the middle area of the bottom surface 402 of the injection molded edge sealing member 40. Shapes of the first positioning protrusion 82 and the second positioning clamp groove 84 each include a triangle and the first positioning protrusion 82 and the second positioning clamp groove 84 are both in the middle area of the bottom bezel 32 of the middle bezel 30. A size of the first positioning protrusion 82 is matched with a size of the first positioning clamp groove 81 and a size of the second positioning protrusion 83 is matched with a size of the second positioning clamp groove 84, so that the second positioning protrusion 83 can be engaged with the second positioning clamp groove 84.

FIG. 19d is an enlarged view of a junction of an injection molded edge sealing member and a middle bezel of another display device according to an embodiment of the present application. In an exemplary implementation, as shown in FIG. 19d, on a plane perpendicular to the display device, shapes of the first positioning clamp groove 81 and the second positioning protrusion 83 each include an elongated strip, central axes of the first positioning clamp groove 81 and the second positioning protrusion 83 each form an acute angle with the plane where the display device is located, and the first positioning clamp groove 81 and the second positioning protrusion 83 are both in the middle area of the bottom surface 402 of the injection molded edge sealing member 40. Shapes of the first positioning protrusion 82 and the second positioning clamp groove 84 each include an elongated strip, central axes of the first positioning protrusion 82 and the second positioning clamp groove 84 each form an acute angle with the plane where the display device is located, and the first positioning protrusion 82 and the second positioning clamp groove 84 are both in the middle area of the bottom bezel 32 of the middle bezel 30. A size of the first positioning protrusion 82 is matched with a size of the first positioning clamp groove 81 and a size of the second positioning protrusion 83 is matched with a size of the second positioning clamp groove 84, so that the second positioning protrusion 83 can be engaged with the second positioning clamp groove 84.

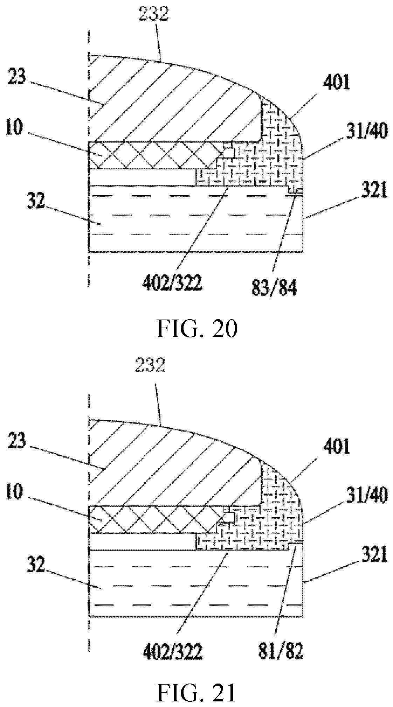

FIG. 20 is a schematic diagram of a sectional structure of a cover plate and an injection molded edge sealing member of another display device according to an embodiment of the present application. In an exemplary implementation, as shown in FIG. 20, the structure of the display device of this exemplary embodiment is substantially the same as that of the embodiment shown in FIG. 11b except that, the bottom surface 402 of the injection molded edge sealing member 40 is provided with a first positioning clamp groove 81 and the first positioning clamp groove 81 is in an edge area of the bottom surface 402 of the injection molded edge sealing member 40. The upper surface 322 of the bottom bezel 32 of the middle bezel 30 is provided with a first positioning protrusion 82 and the first positioning protrusion 82 is in an edge area of the upper surface 322 of the bottom bezel 32. The first positioning protrusion 82 is engaged with the first positioning clamp groove 81, so that the injection molded edge sealing member 40 is fixed on the bottom bezel 32 of the middle bezel 30.

FIG. 21 is a schematic diagram of a sectional structure of a cover plate and an injection molded edge sealing member of another display device according to an embodiment of the present application. In an exemplary implementation, as shown in FIG. 21, the structure of the display device of this exemplary embodiment is substantially the same as that of the embodiment shown in FIG. 16 except that, the bottom surface 402 of the injection molded edge sealing member 40 is provided with a second positioning protrusion 83 and the second positioning protrusion 83 is in an edge area of the bottom surface 402 of the injection molded edge sealing member 40. The upper surface 322 of the bottom bezel 32 of the middle bezel 30 is provided with a second positioning clamp groove 84 and the second positioning clamp groove 84 is in an edge area of the upper surface 322 of the bottom bezel 32. The second positioning protrusion 83 is engaged with the second positioning clamp groove 84, so that the injection molded edge sealing member 40 is fixed on the bottom bezel 32 of the middle bezel 30.

The drawings of the present disclosure only involve structures involved in the present disclosure, and other structures may refer to conventional designs. The embodiments of the present disclosure, i.e., features in the embodiments, may be combined with each other to obtain new embodiments if there is no conflict.

Those of ordinary skills in the art should understand that modifications or equivalent replacements may be made to the technical solutions of the present disclosure without departing from the essence and scope of the technical solutions of the present disclosure, and shall all fall within the scope of the claims of the present disclosure.

## Claims

1. A display device, comprising:
a display substrate;
a cover plate, provided on a side of the display substrate; wherein a chamfer is provided at a corner position of the cover plate, the chamfer is located on a side of the cover plate close to the display substrate, the chamfer has a height in a thickness direction of the cover plate, a ratio of the height of the chamfer to a maximum thickness of the cover plate is greater than or equal to 0.03 and less than or equal to 0.5, the chamfer has a bevel edge, and an included angle between the bevel edge and a plane where the display device is located is greater than or equal to 50 degrees and less than or equal to 80 degrees;
a light shield layer, provided between the display substrate and the cover plate, wherein an orthographic projection of the light shield layer on the plane where the display device is located is overlapped with an orthographic projection of an edge area of the cover plate on the plane where the display device is located; and
an injection molded edge sealing member, comprising a first injection molded part and a second injection molded part, wherein at least a portion of the first injection molded part is provided at a peripheral side of the cover plate and at least a portion of the second injection molded part is provided at a peripheral side of the display substrate.

2. The display device according to claim 1, wherein the ratio of the height of the chamfer to the maximum thickness of the cover plate is greater than or equal to 0.04 and less than or equal to 0.4.

3. The display device according to claim 2, wherein the ratio of the height of the chamfer to the maximum thickness of the cover plate is greater than or equal to 0.1 and less than or equal to 0.2.

4. The display device according to claim 1, wherein a first end of the first injection molded part is connected with the second injection molded part, and an end face of a second end of the first injection molded part is substantially flush with a surface of the cover plate away from the display substrate.

5. The display device according to claim 1, wherein the first injection molded part and the second injection molded part are connected as a whole and comprise a same material.

6. The display device according to claim 1, wherein the first injection molded part is annular and is provided around a periphery of the cover plate.

7. The display device according to claim 6, wherein a width of an annulus of the first injection molded part is greater than or equal to 0.05 mm and less than or equal to 1mm.

8. The display device according to any one of claims 1 to 7, wherein at least a portion of the second injection molded edge sealing part is provided in the display substrate.

9. The display device according to any one of claims 1 to 7, further comprising a middle bezel, the middle bezel comprising a side bezel and a bottom bezel, wherein the side bezel is provided on a side of the injection molded edge sealing member away from the cover plate, and the bottom bezel is located on a side of the display substrate away from the cover plate.

10. The display device according to claim 9, wherein an orthographic projection of the side bezel of the middle bezel on the plane where the display device is located is not overlapped with an orthographic projection of the cover plate on the plane where the display device is located.

11. The display device according to claim 9, wherein the injection molded edge sealing member further comprises a third injection molded part, and the third injection molded part is provided between the display substrate and the bottom bezel.

12. The display device according to claim 11, wherein the third injection molded part and the second injection molded part are connected as a whole and comprise a same material.

13. The display device according to claim 9, further comprising a sealant layer, wherein the sealant layer is provided between the injection molded edge sealing member and the middle bezel.

14. The display device according to any one of claims 1 to 7, further comprising a middle bezel, wherein the middle bezel comprises a bottom bezel, the bottom bezel is located on a side of the display substrate away from the cover plate, and the injection molded edge sealing member is provided on the bottom bezel.

15. The display device according to claim 14, wherein the cover plate has an outer surface away from the display substrate, and an edge area of the outer surface is arc-shaped.

16. The display device according to claim 14, wherein the cover plate has an outer surface away from the display substrate, and the outer surface is planar.

17. The display device according to claim 15, wherein the injection molded edge sealing member has a first side surface away from a peripheral side face of the cover plate, the first side surface is arc-shaped, and the first side surface of the injection molded edge sealing member is connected with the edge area of the outer surface of the cover plate to form an arc surface.

18. The display device according to claim 16, wherein the injection molded edge sealing member has a top surface away from the bottom bezel, a first side surface away from a peripheral side face of the cover plate, and a filleted corner connecting the top surface with the first side surface, the top surface is planar, and the top surface is substantially flush with the outer surface of the cover plate.

19. The display device according to claim 14, wherein the injection molded edge sealing member has a first side surface away from a peripheral side face of the cover plate, the first side surface is arc-shaped, the bottom bezel has a second side surface, the second side surface is arc-shaped, and the first side surface is connected with the second side surface to form an arc surface.

20. The display device according to claim 14, wherein the injection molded edge sealing member has a first side surface away from a peripheral side face of the cover plate, the first side surface is planar, the bottom bezel has a second side surface, the second side surface is planar, and the first side surface is substantially flush with the second side surface.

21. The display device according to claim 14, wherein the injection molded edge sealing member has a bottom surface close to the bottom bezel, the bottom surface is planar, the bottom bezel has an upper surface close to the injection molded edge sealing member, the upper surface is planar, and the bottom surface is connected with the upper surface.

22. The display device according to claim 14, wherein the injection molded edge sealing member has a bottom surface close to the bottom bezel, the bottom surface is provided with a first positioning clamp groove, the bottom bezel has an upper surface close to the injection molded edge sealing member, the upper surface is provided with a first positioning protrusion, and the first positioning protrusion is engaged with the first positioning clamp groove.

23. The display device according to claim 22, wherein the first positioning clamp groove is located in a middle area of the bottom surface of the injection molded edge sealing member and the first positioning protrusion is located in a middle area of the upper surface of the bottom bezel; or, the first positioning clamp groove is located in an edge area of the bottom surface of the injection molded edge sealing member and the first positioning protrusion is located in an edge area of the upper surface of the bottom bezel.

24. The display device according to claim 22, wherein a section of the first positioning protrusion perpendicular to the plane where the display device is located comprises at least one of a rectangle, a trapezoid, a triangle, and an elongated shape provided obliquely with respect to the plane where the display device is located.

25. The display device according to claim 22, wherein a section of the first positioning clamp groove perpendicular to the plane where the display device is located comprises at least one of a rectangle, a trapezoid, a triangle, and an elongated shape provided obliquely with respect to the plane where the display device is located.

26. The display device according to claim 14, wherein the injection molded edge sealing member has a bottom surface close to the bottom bezel, the bottom surface is provided with a second positioning protrusion, the bottom bezel has an upper surface close to the injection molded edge sealing member, the upper surface is provided with a second positioning clamp groove, and the second positioning protrusion is engaged with the second positioning clamp groove.

27. The display device according to claim 26, wherein the second positioning protrusion is located in an middle area of the bottom surface of the injection molded edge sealing member and the second positioning clamp groove is located in an middle area of the upper surface of the bottom bezel; or, the second positioning protrusion is located in an edge area of the bottom surface of the injection molded edge sealing member and the second positioning clamp groove is located in an edge area of the upper surface of the bottom bezel.

28. The display device according to claim 26, wherein a section of the second positioning protrusion perpendicular to the plane where the display device is located comprises at least one of a rectangle, a trapezoid, a triangle, and an elongated shape provided obliquely with respect to the plane where the display device is located.

29. The display device according to claim 26, wherein a section of the second positioning clamp groove perpendicular to the plane where the display device is located comprises at least one of a rectangle, a trapezoid, a triangle, and an elongated shape provided obliquely with respect to the plane where the display device is located.

30. The display device according to any one of claims 1 to 7, wherein the display substrate comprises a first fixation region, a bending region and a second fixation region provided continuously, and the second fixation region is provided on a backlight side of the first fixation region through the bending region.

31. An injection mold, comprising an upper mold core and a lower mold core, wherein the upper mold core and the lower mold core are configured to enclose the display substrate and the cover plate in the display device according to any one of claims 1 to 30 to form an injection mold cavity connected with edges of the display substrate and the cover plate, the injection mold cavity is configured to accommodate an injection mold fluid forming the injection molded edge sealing member in the display device, and the injection mold cavity comprises an inner side face, the inner side face is located at the peripheral side of the cover plate, and a gap is formed between the inner side face and a peripheral side face of the cover plate.

32. The injection mold according to claim 31, wherein a junction of the upper mold core and the lower mold core is substantially flush with a surface of the cover plate away from the display substrate.

33. The injection mold according to claim 31, wherein a degassing hole connected with the cover plate is provided in the lower mold core.
